# EUROPEAN PATENT APPLICATION

(11) **EP 4 560 683 A1**
(43) Date of publication of application: **28.05.2025**
(21) Application number: 23842948.4
(22) Date of filing: 18.07.2023
(51) Int. Cl.: H01L 21/302, C23F 1/12, H01L 21/3065

(54) **DRY ETCHING METHOD, CLEANING METHOD, AND MANUFACUTRING METHOD FOR SEMICONDUCTOR DEVICE**

(30) Priority: 19.07.2022 JP 2022114733
(71) Applicant: Central Glass Company, Limited, Ube-shi, Yamaguchi 755-0001 (JP)
(72) Inventor: YAMAUCHI, Kunihiro, Tokyo 101-0054 (JP); KITAYAMA, Hikaru, Tokyo 101-0054 (JP); KIKUCHI, Akiou, Tokyo 101-0054 (JP)
(74) Representative: Manitz Finsterwald Patent- und Rechtsanwaltspartnerschaft mbB
(86) International application number: PCT/JP2023/026175
(87) International publication number: WO 2024/019025

(57) **Abstract**

A dry etching method of the present disclosure includes bringing a β-diketone and a gas containing a halogen atom in its molecule into contact with an etching target film containing a metal, an oxide of the metal, or a nitride of the metal formed on a surface of a workpiece to etch the etching target film, the metal containing at least one selected from the group consisting of In, Ga, Cu, Co, Fe, Sn, Zn, Al, Ta, and As.

## Description

### TECHNICAL FIELD

The present disclosure relates to dry etching methods, cleaning methods, and methods for producing semiconductor devices.

### BACKGROUND ART

Some semiconductor device production processes include etching a metal film formed on a substrate as a wiring material, a metal gate material, an electrode material, or a magnetic material. For example, the etching of such a metal film is known to use hexafluoroacetylacetone (HFAc), a β-diketone that can form a complex with the metal.

Meanwhile, when a metal film is formed using a film-forming device in the semiconductor element production process, unnecessary metal films and the like can adhere to the inner surfaces of the film-forming device, such as the inner walls of the film-forming chamber of the film-forming device, and therefore they need to be removed. A cleaning method using the etching function of a β-diketone is also known to remove such unnecessary metal films and the like in the internally heated chamber after the substrate is taken out of the chamber. For example, a dry cleaning method is known which includes bringing HFAc into contact with a metal oxide film to react and remove the metal oxide film as a metal complex (Patent Literature 1).

Also known is a dry cleaning method using a β-diketone in combination with oxygen to facilitate the reaction and removal of a metal film as a metal complex (Patent Literature 2 and Patent Literature 3). Studies have also been carried out on a metal film cleaning method which includes thermally reacting a metal film with a gas containing a chlorine atom in its molecule, followed by reacting a β-diketone with the specific metal in the metal film to remove the product (Patent Literature 4), as well as methods further using various additive gases in addition to a β-diketone to efficiently etch a metal film, such as an example using HF as an additive gas with a β-diketone (Patent Literature 5); examples using nitrogen oxides (NO, N₂O, NO₂) as additive gases (Patent Literatures 6 to 8); and an example using a halogen-containing substance as an additive gas (Patent Literature 9).

### CITATION LIST

### - Patent Literature

Patent Literature 1: JP 2001-176807 A
Patent Literature 2: JP H11-140652 A
Patent Literature 3: JP 2012-149288 A
Patent Literature 4: JP 2005-116716 A
Patent Literature 5: JP 2006-080103 A
Patent Literature 6: JP 2013-194307 A
Patent Literature 7: JP 2019-169724 A
Patent Literature 8: WO 2021/79624 A
Patent Literature 9: JP 2017-059824 A

### SUMMARY OF INVENTION

### - Technical Problem

Generally, when metal films adhered to surfaces other than the surface of a substrate are etched after a metal film is deposited on the substrate surface, as the temperature inside the chamber becomes high, and therefore it is desirable that the temperature of the inner walls (e.g., side walls), for example, be as low as possible. However, if an attempt is made to etch away the metal film to be removed using a β-diketone and an additive gas such as oxygen at a low temperature (e.g., around 250°C), a problem arises in that the etching may not proceed.

In addition, there is another concern that for some types of metal films, for example, decomposition of HFAc may be observed at a temperature lower than the decomposition temperature of HFAc (375°C) due to the catalytic effect of the metal and its oxidized metal, so that a film mainly containing HFAc-derived carbons may remain on the substrate after etching. Moreover, for example, in the method described in Patent Literature 4 where a metal film containing Ti, Zr, and Pb is thermally reacted with hydrogen chloride (HCl) gas at 300°C or 500°C, the temperature during the thermal reaction may be higher depending on the type of metal film. Since a lower etching temperature is preferred also from the standpoint of the corrosion resistance of the etching apparatus, there has been a need to develop an etching gas that can provide a reduction in etching temperature and an increase in etching rate at the same time.

In view of the above problems, the present disclosure aims to provide a dry etching method using a gas composition that enables plasmaless etching of a metal oxide film, a metal nitride film, or a metal film.

### - Solution to Problem

As a result of extensive studies, the present inventors have found that using a β-diketone and a gas containing a halogen atom in its molecule (hereinbelow, the gas may be referred to as "additive gas") as an etching gas enables etching of a film of an oxide of a specific metal such as In, etc. at a high etching rate. Thus, the present disclosure has been completed.

Specifically, the present disclosure provides dry etching methods, cleaning methods, and methods for producing a semiconductor device described in the following embodiments (1) to (30).
(1) A dry etching method, including bringing a β-diketone and a gas containing a halogen atom in its molecule into contact with an etching target film containing a metal, an oxide of the metal, or a nitride of the metal formed on a surface of a workpiece to etch the etching target film, the metal containing at least one selected from the group consisting of In, Ga, Cu, Co, Fe, Sn, Zn, Al, Ta, and As.
(2) The dry etching method according to the embodiment (1), wherein the metal, the oxide of the metal, or the nitride of the metal is at least one selected from the group consisting of indium oxides, gallium oxides, copper oxides, cobalt oxides, iron oxides, tin oxides, zinc oxides, aluminum oxides, tantalum oxides, indium gallium zinc oxides, indium tin oxides, gallium nitride, indium nitride, aluminum nitride, tantalum nitride, aluminum gallium nitrides, indium gallium nitrides, and indium gallium arsenide.
(3) The dry etching method according to the embodiment (1) or (2), wherein the gas containing a halogen atom in its molecule is at least one selected from the group consisting of HF, F₂, ClF₃, IF₇, HCl, and Cl₂.
(4) The dry etching method according to any one of the embodiments (1) to (3), wherein the β-diketone is at least one selected from the group consisting of hexafluoroacetylacetone, trifluoroacetylacetone, and acetylacetone.
(5) The dry etching method according to any one of the embodiments (1) to (4), wherein the etching is performed without plasma.
(6) The dry etching method according to any one of the embodiments (1) to (5), wherein an etching gas A containing the β-diketone and the gas containing a halogen atom in its molecule is brought into contact with the etching target film.
(7) The dry etching method according to the embodiment (6), wherein the etching target film has a temperature of 50°C or higher and 300°C or lower when the etching gas A is brought into contact with the etching target film.
(8) The dry etching method according to the embodiment (6) or (7), wherein the etching gas A contains the β-diketone in an amount of 10% by volume or more and 90% by volume or less.
(9) The dry etching method according to any one of the embodiments (6) to (8), wherein the etching gas A contains the gas containing a halogen atom in its molecule in an amount of 0.1% by volume or more and 50% by volume or less.
(10) The dry etching method according to any one of the embodiments (6) to (9), wherein the etching gas A further contains at least one oxidative gas selected from the group consisting of O₂, NO, NO₂, and N₂O.
(11) The dry etching method according to any one of the embodiments (6) to (10), wherein the etching gas A further contains at least one inert gas selected from the group consisting of N₂, Ar, He, Ne, and Kr.
(12) The dry etching method according to any one of the embodiments (6) to (11), wherein a pressure in a processing vessel in which the workpiece with the etching target film formed thereon is placed is 0.1 kPa or higher and 101.3 kPa or lower when the etching gas A is brought into contact with the etching target film.
(13) The dry etching method according to any one of the embodiments (1) to (5), including: a first etching step including bringing an etching gas B containing the gas containing a halogen atom in its molecule into contact with the etching target film; and a second etching step including bringing an etching gas C containing the β-diketone into contact with the etching target film.
(14) The dry etching method according to the embodiment (13), wherein the etching target film has a temperature of 50°C or higher and 300°C or lower when the etching gas B is brought into contact with the etching target film and when the etching gas C is brought into contact with the etching target film.
(15) The dry etching method according to the embodiment (13) or (14), wherein at least one of the etching gas B or the etching gas C further contains at least one oxidative gas selected from the group consisting of O₂, NO, NO₂, and N₂O.
(16) The dry etching method according to any one of the embodiments (13) to (15), wherein at least one of the etching gas B or the etching gas C further contains at least one inert gas selected from the group consisting of N₂, Ar, He, Ne, and Kr.
(17) The dry etching method according to any one of the embodiments (13) to (16), wherein a pressure in a processing vessel in which the workpiece with the etching target film formed thereon is placed is 0.1 kPa or higher and 101.3 kPa or lower when the etching gas B is brought into contact with the etching target film and when the etching gas C is brought into contact with the etching target film.
(18) A cleaning method, including bringing a β-diketone and a gas containing a halogen atom in its molecule into contact with a deposit containing a metal, an oxide of the metal, or a nitride of the metal deposited on a surface of a processing vessel in a substrate processing apparatus to remove the deposit, the metal containing at least one selected from the group consisting of In, Ga, Cu, Co, Fe, Sn, Zn, Al, Ta, and As.
(19) The cleaning method according to the embodiment (18), wherein the metal, the oxide of the metal, or the nitride of the metal is at least one selected from the group consisting of indium oxides, gallium oxides, copper oxides, cobalt oxides, iron oxides, tin oxides, zinc oxides, aluminum oxides, tantalum oxides, indium gallium zinc oxides, indium tin oxides, gallium nitride, indium nitride, aluminum nitride, tantalum nitride, aluminum gallium nitrides, indium gallium nitrides, and indium gallium arsenide.
(20) The cleaning method according to the embodiment (18) or (19), wherein at least one oxidative gas selected from the group consisting of O₂, NO, NO₂, and N₂O is further brought into contact with the deposit.
(21) A method for producing a semiconductor device, including applying the dry etching method according to any one of the embodiments (1) to (17) to a film containing a metal, an oxide of the metal, or a nitride of the metal on a substrate to etch the film, the metal containing at least one selected from the group consisting of In, Ga, Cu, Co, Fe, Sn, Zn, Al, Ta, and As.
(22) A dry etching method, including bringing a β-diketone and a gas containing a chlorine atom in its molecule into contact with an etching target film containing a metal, an oxide of the metal, or a nitride of the metal formed on a surface of a workpiece to etch the etching target film, the metal containing at least two selected from the group consisting of In, Co, Fe, As, Al, Ga, Sn, and Zn, the at least two including at least one selected from Ga, Sn, and Zn.
(23) The dry etching method according to the embodiment (22), wherein the metal, the oxide of the metal, or the nitride of the metal is at least one selected from the group consisting of indium gallium zinc oxides, indium zinc oxides, aluminum zinc oxides, gallium zinc oxides, indium gallium zinc tin oxides, indium tin zinc oxides, indium tin oxides, aluminum gallium nitrides, indium gallium nitrides, and indium gallium arsenide.
(24) The dry etching method according to the embodiment (22) or (23), wherein the gas containing a chlorine atom in its molecule is at least one selected from the group consisting of HCl, Cl₂, BCl₃, and SiCl₄.
(25) The dry etching method according to any one of the embodiments (22) to (24), wherein the β-diketone is at least one selected from the group consisting of hexafluoroacetylacetone, trifluoroacetylacetone, and acetylacetone.
(26) The dry etching method according to any one of the embodiments (22) to (25), wherein the etching is performed without plasma.
(27) The dry etching method according to any one of the embodiments (22) to (26), wherein an etching gas D containing the β-diketone and the gas containing a chlorine atom in its molecule is brought into contact with the etching target film.
(28) The dry etching method according to the embodiment (27), wherein the etching gas D contains the gas containing a chlorine atom in its molecule in an amount of 1% by volume or more and 60% by volume or less.
(29) The dry etching method according to any one of the embodiments (22) to (26), including: a third etching step including bringing an etching gas E containing the gas containing a chlorine atom in its molecule into contact with the etching target film; and a fourth etching step including bringing an etching gas F containing the β-diketone into contact with the etching target film.
(30) A method for producing a semiconductor device, comprising
   applying the dry etching method according to any one of the embodiments (22) to (29) to a film containing a metal, an oxide of the metal, or a nitride of the metal on a substrate to etch the film, the metal containing at least two selected from the group consisting of In, Co, Fe, As, Al, Ga, Sn, and Zn, the at least two including at least one selected from Ga, Sn, and Zn.

### - Advantageous Effects of Invention

The present disclosure provides such an effect that using a β-diketone and a gas containing a halogen atom in its molecule as an etching gas enables etching of a film of an oxide of a specific metal such as In, etc. at a low temperature and at a high etching rate.

### BRIEF DESCRIPTION OF DRAWINGS

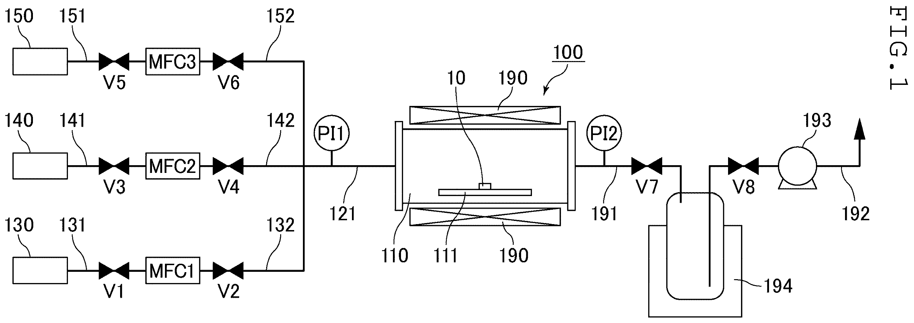

FIG. 1 is a schematic view of an etching apparatus used in examples of the present disclosure.

### DESCRIPTION OF EMBODIMENTS

Hereinafter, the present disclosure is described in detail. The present disclosure is not limited to the following embodiments and can be implemented as appropriate based on the common knowledge of those skilled in the art without impairing the gist of the present disclosure.

### <Dry etching method I>

A dry etching method I according to the present disclosure includes bringing a β-diketone and a gas containing a halogen atom in its molecule into contact with an etching target film containing at least one metal, an oxide of the metal, or a nitride of the metal formed on a surface of a workpiece to etch the etching target film, the at least one metal being selected from the group consisting of In, Ga, Cu, Co, Fe, Sn, Zn, Al, Ta, and As.

When a β-diketone and a gas containing a halogen atom in its molecule as an additive gas, such as hydrogen fluoride (HF), are brought into contact with the metal film, metal oxide film, or metal nitride film, the dry etching method I of the present disclosure allows HF to fluorinate the film surface into a metal fluoride to increase the reactivity with the β-diketone, thereby promoting the formation of a complex. This advantageously results in a lower etching temperature and an increased etching rate. The dry etching method I of the present disclosure can provide a dry etching method capable of etching a difficult-to-etch etching target film at a temperature of 350°C or lower, or even 300°C or lower.

The metal, the oxide of the metal, or the nitride of the metal contained in the etching target film to be etched by the dry etching method I of the present disclosure may be an alloy containing two or more of the metals listed above, an oxide of the alloy, or a nitride of the alloy. Examples of the metal, the oxide of the metal, or the nitride of the metal include indium (In), gallium (Ga), copper (Cu), cobalt (Co), iron (Fe), tin (Sn), zinc (Zn), aluminum (Al), tantalum (Ta), arsenic (As), indium gallium arsenide, indium oxides (InO_{q} (q is 1 or greater and 2 or smaller), in particular, In₂O₃), gallium oxides (GaOₚ (p is 1 or greater and 2 or smaller), in particular, Ga₂O₃), copper oxides [copper(I) oxide, copper(II) oxide], cobalt oxides, iron oxides, tin oxides, zinc oxides, aluminum oxides (AlOᵥ (v is 1 or greater and 2 or smaller), in particular, Al₂O₃), tantalum oxides, indium gallium zinc oxides [InₐGa_{b}Zn_{c}O_{d} (a and b are each 1 or greater and 3 or smaller, c is 0.5 or greater and 4 or smaller, and d is 4 or greater and 10 or smaller; abbreviated as "IGZO"); particularly preferably represented by (InGaO₃)ₐ(ZnO)_{c} such as InGaZnO₄ and In₂Ga₂ZnO₇], indium tin oxides (mixtures of indium oxide (In₂O₃) and tin oxide (SnO₂), abbreviated as "ITO"), indium nitride, gallium nitride, aluminum nitride, tantalum nitride, aluminum gallium nitrides, copper nitride, cobalt nitride, iron nitride, tin(IV) nitride, zinc nitride, and indium gallium nitrides. The metal, the oxide of the metal, or the nitride of the metal contained in the etching target film is preferably at least one selected from the group consisting of indium oxides, gallium oxides, copper oxides, cobalt oxides, iron oxides, tin oxides, zinc oxides, aluminum oxides, tantalum oxides, indium gallium zinc oxides, indium tin oxides, gallium nitride, indium nitride, aluminum nitride, tantalum nitride, aluminum gallium nitrides, indium gallium nitrides, and indium gallium arsenide.

In the dry etching method I of the present disclosure, examples of the workpiece include silicon substrates, compound semiconductor substrates, quartz substrates, and glass substrates. In addition to the etching target film, a silicon film, a silicon oxide film, a silicon nitride film, a wiring film of a metal other than the metal, or other film may be formed on the surface of the workpiece.

The etching target film may be formed on the surface of the workpiece by any method, such as a chemical vapor deposition (CVD) method or a sputtering method. The etching target film may also have any thickness. For example, the etching target film may have a thickness of 0.1 nm or more and 1 µm or less.

In the dry etching method I of the present disclosure, a β-diketone and a gas containing a halogen atom in its molecule are used as an etching gas.

Any type of β-diketone may be used. Preferred is at least one selected from the group consisting of hexafluoroacetylacetone (HFAc, 1,1,1,5,5,5-hexafluoro-2,4-pentanedione), trifluoroacetylacetone (1,1,1-trifluoro-2,4-pentanedione), and acetylacetone (2,4-pentanedione).

Any type of gas containing a halogen atom in its molecule may be used. Preferred is at least one selected from the group consisting of HF, F₂, ClF₃, IF₇, HCl, and Cl₂. In the case where the gas is used in admixture with the β-diketone, HF or HCl is more preferred.

In the dry etching method I of the present disclosure, it is preferred to bring the β-diketone and the gas containing a halogen atom in its molecule into contact with the etching target film without plasma. This is because if the workpiece is a semiconductor device substrate and is brought into contact with plasma gas, the plasma gas can cause electrical damage to the substrate.

### (First dry etching method)

As the dry etching method I of the present disclosure, a first dry etching method is described below which includes simultaneously bringing the β-diketone and the gas containing a halogen atom in its molecule (additive gas) into contact with the etching target film. In the first dry etching method, an etching gas A containing the β-diketone and the additive gas is brought into contact with the etching target film. The etching gas A contains at least the β-diketone and the gas containing a halogen atom in its molecule.

Examples of the β-diketone in the etching gas A include those listed for the β-diketone above.

The etching gas A preferably contains the β-diketone in an amount of 5% by volume or more and 95% by volume or less, more preferably 10% by volume or more and 90% by volume or less. Too low a β-diketone content in the etching gas A tends to lead to a decrease in etching rate, whereas too high a β-diketone content makes the etching gas too expensive. Moreover, either too low or too high an additive gas content in the etching gas A may inhibit the progress of etching.

The etching gas A preferably contains the additive gas in an amount of 0.1% by volume or more and 50% by volume or less, more preferably 1% by volume or more and 40% by volume or less, still more preferably 5% by volume or more and 30% by volume or less.

The volume ratio of the β-diketone to the additive gas (the gas containing a halogen atom in its molecule) in the etching gas A may be β-diketone:additive gas = 1:0.01 to 100, or β-diketone:additive gas = 1:0.1 to 10, or β-diketone:additive gas = 1:0.1 to 1.

The etching gas A may further contain at least one oxidative gas selected from the group consisting of O₂, NO, NO₂, and N₂O.

The etching gas A may further contain at least one inert gas selected from the group consisting of N₂, Ar, He, Ne, and Kr.

When an oxidative gas is used, the percentage of the oxidative gas in the etching gas A may be 10% by volume or more and 90% by volume or less.

When the etching gas A contains an inert gas, the percentage of the inert gas in the etching gas A is preferably 1% by volume or more and 90% by volume or less.

In the first dry etching method, etching is preferably performed with the workpiece placed in a processing vessel. The first dry etching method preferably includes subjecting the interior of the processing vessel to a reduced pressure condition after bringing the etching gas A into contact with the etching target film. This is because by-products generated during the etching can be removed.

The term "reduced pressure condition" means a condition where the pressure in the processing vessel is lower than the pressure during the etching and is approximately 0.133 kPa or lower.

The first dry etching method preferably includes purging the interior of the processing vessel with an inert gas after bringing the etching gas A into contact with the etching target film. This is because by-products generated during the etching can be removed.

The first dry etching method may include subjecting the interior of the processing vessel to a reduced pressure condition, followed by purging the interior of the processing vessel with an inert gas.

### (Second dry etching method)

Next, as the dry etching method I of the present disclosure, a second dry etching method is described which includes a first etching step including bringing an etching gas B containing the gas containing a halogen atom in its molecule into contact with the etching target film, and a second etching step including bringing an etching gas C containing the β-diketone into contact with the etching target film. The etching gas B contains at least the gas containing a halogen atom in its molecule (additive gas), while the etching gas C contains at least the β-diketone.

Examples of the β-diketone in the etching gas C include those listed for the β-diketone above.

Although the etching gas B may consist only of the additive gas, and the etching gas C may consist only of the β-diketone, the etching gas B and/or the etching gas C may further contain at least one oxidative gas selected from the group consisting of O₂, NO, NO₂, and N₂O. The etching gas B and/or the etching gas C may further contain at least one inert gas selected from the group consisting of N₂, Ar, He, Ne, and Kr.

The percentage of the additive gas in the etching gas B can be 10% by volume or more and 100% by volume or less, for example. The percentage of the β-diketone in the etching gas C can be 10% by volume or more and 100% by volume or less.

When the etching gas B and the etching gas C each contain an oxidative gas, the percentage of the oxidative gas in each of the etching gas B and the etching gas C can be 10% by volume or more and 90% by volume or less.

When the etching gas B and the etching gas C each contain an inert gas, the percentage of the inert gas in each of the etching gas B and the etching gas C is preferably 1% by volume or more and 90% by volume or less.

In the second dry etching method, etching is preferably performed with the workpiece placed in a processing vessel. The second dry etching method preferably includes subjecting the interior of the processing vessel to a reduced pressure condition after bringing the etching gas B and the etching gas C into contact with the etching target film. This is because by-products generated during the etching can be removed.

The second dry etching method preferably includes purging the interior of the processing vessel with an inert gas after bringing the etching gas B and the etching gas C into contact with the etching target film. This is because by-products generated during the etching can be removed.

The second dry etching method may include subjecting the interior of the processing vessel to a reduced pressure condition, followed by purging the interior of the processing vessel with an inert gas.

In the second dry etching method of the present disclosure, the above steps may be repeated multiple times to repeatedly etch the etching target film. Since one cycle of etching steps can etch the etching target film only to a certain thickness, a layer having a desired thickness can be precisely etched by specifying the number of cycles.

### (First dry etching method using etching apparatus)

The first dry etching method can be implemented, for example, using an etching apparatus as shown in FIG. 1. FIG. 1 is a schematic view of the etching apparatus used in examples of the present disclosure. The first dry etching method is specifically described using the etching apparatus shown in FIG. 1 as an example.

In the first dry etching method, an etching gas A containing a β-diketone and a gas containing a halogen atom in its molecule is brought into contact with an etching target film.

First, a workpiece 10, on which an etching target film containing a metal, an oxide of the metal, or a nitride of the metal is formed, is placed on a placement unit 111 in a processing vessel 110. Next, a vacuum pump 193 is used to evacuate the interior of the processing vessel 110, a pipe 121, pipes 131 and 132, pipes 141 and 142, pipes 151 and 152, a liquid nitrogen trap 194, and pipes 191 and 192 to a predetermined pressure, followed by heating the workpiece 10 with heating means 190.

When the workpiece 10 reaches a predetermined temperature, a β-diketone gas and an additive gas are supplied to the pipe 121 at predetermined flow rates from a β-diketone gas supply unit 130 and an additive gas supply unit 140, respectively. The β-diketone gas supply unit 130 controls the amount of supply using valves V1 and V2 and a mass flow control means MFC1 to supply the β-diketone gas from the pipes 131 and 132 to the pipe 121. The additive gas supply unit 140 controls the amount of supply using valves V3 and V4 and a mass flow control means MFC2 to supply the additive gas from the pipes 141 and 142 to the pipe 121.

Here, an inert gas may be supplied to the pipe 121 at a predetermined flow rate from an inert gas supply unit 150. The inert gas supply unit 150 controls the amount of supply using valves V5 and V6 and a mass flow control means MFC3 to supply the inert gas from the pipes 151 and 152 to the pipe 121.

Moreover, an oxidative gas may be supplied to the pipe 121 at a predetermined flow rate from an oxidative gas supply unit (not shown).

Moreover, in FIG. 1, the reference signs PI1 and PI2 each represent a pressure indicator. Their readings are used to control each mass flow control means and each valve.

The β-diketone gas and the additive gas are mixed at a predetermined compositional ratio and supplied to the processing vessel 110. While introducing the mixed gas into the processing vessel 110, the pressure in the processing vessel 110 is controlled to a predetermined pressure. The etching gas is reacted with the etching target film containing a metal, an oxide of the metal, or a nitride of the metal for a predetermined period of time to form a complex for etching. This first dry etching method allows for plasmaless etching without plasma and eliminates the need to excite the etching gas using plasma or the like during the etching. The flow rate of the etching gas may be appropriately set according to the volume, pressure, and other conditions of the processing vessel.

It should be noted that etching associated with plasma means that gas or the like at about 0.01 to 1.33 kPa, for example, is introduced into a reactor, and a highfrequency power is applied to an outer coil or a counter electrode to generate low-temperature gas plasma in the reactor, thereby performing etching with the active chemical species such as ions and radicals formed in the plasma.

The dry etching method I of the present disclosure can provide contact with the gas without plasma to perform dry etching without generating the gas plasma described above.

After completion of the etching, the heating with the heating means 190 is stopped to lower the temperature. At the same time, the vacuum pump 193 is stopped, followed by purging with an inert gas to release the vacuum. As described above, the dry etching method using the etching apparatus described above can etch the etching target film containing a metal, an oxide of the metal, or a nitride of the metal.

### (Etching conditions in first dry etching method)

In the first dry etching method, the temperature of the etching target film during the etching may be any temperature at which the complex can vaporize, and is preferably 50°C or higher and 350°C or lower, more preferably 50°C or higher and 300°C or lower, still more preferably 200°C or higher and 300°C or lower. The above temperature range can result in high etching efficiency and low substrate damage.

The temperature of the surface of the workpiece is substantially equal to the temperature of the etching target film. When a β-diketone and a gas containing a halogen atom in its molecule are brought into contact with the heated etching target film, the metal or the like on the surface of the etching target film may be fluorinated by the gas containing a halogen atom in its molecule to form a metal fluoride, which may then react with the β-diketone to form a complex on the surface of the etching target film. This complex has a high vapor pressure and thus can vaporize to remove the etching target film.

Moreover, the pressure in the processing vessel during the etching is not limited, but is usually 0.1 kPa or higher and 101.3 kPa or lower.

The pressure in the processing vessel during the etching is preferably 2.67 kPa or higher and 39.9 kPa or lower, more preferably 2.67 kPa or higher and 26.7 kPa or lower, in order to achieve a sufficient etching rate.

The processing time for etching is not limited, and is preferably within 60 minutes in consideration of the efficiency of the semiconductor device production process. Here, the processing time for etching refers to the time from when the etching gas is introduced into the processing vessel in which the workpiece has been placed to when the mixed gas in the processing vessel is then exhausted by the vacuum pump or the like to terminate the etching process.

### (Second dry etching method using etching apparatus)

The second dry etching method can be implemented, for example, using an etching apparatus as shown in FIG. 1. The second dry etching method is specifically described below using the etching apparatus shown in FIG. 1 as an example.

In the second dry etching method, an etching gas B containing a gas containing a halogen atom in its molecule is brought into contact with an etching target film, and then an etching gas C containing a β-diketone is brought into contact with the etching target film.

First, a workpiece 10, on which an etching target film containing a metal, an oxide of the metal, or a nitride of the metal is formed, is placed on a placement unit 111 in a processing vessel 110. Next, a vacuum pump 193 is used to evacuate the interior of the processing vessel 110, a pipe 121, pipes 131 and 132, pipes 141 and 142, pipes 151 and 152, a liquid nitrogen trap 194, and pipes 191 and 192 to a predetermined pressure, followed by heating the workpiece 10 with heating means 190.

When the workpiece 10 reaches a predetermined temperature, first, an additive gas as an etching gas B is supplied at a predetermined flow rate from an additive gas supply unit 140 to the pipe 121. Here, an inert gas may be supplied at a predetermined flow rate from an inert gas supply unit 150 to the pipe 121. Moreover, an oxidative gas may be supplied at a predetermined flow rate from an oxidative gas supply unit (not shown) to the pipe 121. While introducing the additive gas as the etching gas B or the additive gas and the inert gas into the processing vessel 110, the pressure in the processing vessel 110 is controlled to a predetermined pressure. The etching gas B is introduced into the processing vessel 110 for a predetermined period of time so that the additive gas can adsorb onto the etching target film.

After the etching gas B containing the additive gas is evacuated, a β-diketone gas as an etching gas C is supplied at a predetermined flow rate from a β-diketone gas supply unit 130 to the pipe 121. Here, the inert gas may be supplied at a predetermined flow rate from the inert gas supply unit 150 to the pipe 121. While introducing the β-diketone gas as the etching gas C or the β-diketone gas and the inert gas into the processing vessel 110, the pressure in the processing vessel 110 is controlled to a predetermined pressure. The etching gas C is introduced into the processing vessel 110 for a predetermined period of time so that the etching target film can be etched.

The second dry etching method of the present disclosure may include repeated cycles, each of which includes the first etching step including introducing the additive gas into the processing vessel 110 and the second etching step including introducing the β-diketone gas into the processing vessel 110.

In the second dry etching method of the present disclosure, the etching conditions in one cycle may be set to predetermined conditions to control the thickness of the etching target film that can be etched in one cycle. Thus, the thickness of the etching target film that can be etched in one cycle may be set to be small to precisely control the etching thickness.

The second dry etching method of the present disclosure preferably includes the first etching step, followed by the second etching step. Also preferably, every cycle includes subjecting the interior of the processing vessel to a reduced pressure condition or purging the interior of the processing vessel with an inert gas. The first etching step may be followed by subjecting the interior of the processing vessel to a reduced pressure condition or purging the interior of the processing vessel with an inert gas.

It should be noted that the second dry etching method also allows for plasmaless etching without plasma and eliminates the need to excite the etching gas using plasma or the like during the etching. The flow rates of the β-diketone gas and the additive gas may be appropriately set according to the volume, pressure, and other conditions of the processing vessel.

Thus, the second dry etching method using the etching apparatus can bring the gas into contact with the etching target film without plasma to perform dry etching without generating the gas plasma described above.

After completion of the etching steps, the heating with the heating means 190 is stopped to lower the temperature. At the same time, the vacuum pump 193 is stopped, followed by purging with an inert gas to release the vacuum. Thus, the etching target film can be etched.

### (Etching conditions in second dry etching method)

In the second dry etching method, the temperature of the etching target film in the first etching step and the temperature of the etching target film in the second etching step may each be any temperature at which the complex can vaporize, and are each preferably 50°C or higher and 350°C or lower, more preferably 50°C or higher and 300°C or lower, still more preferably 200°C or higher and 300°C or lower. The above temperature range can result in high etching efficiency and low substrate damage.

Moreover, when the etching gas B is brought into contact with the etching target film and when the etching gas C is brought into contact with the etching target film, the pressure in the processing vessel in which the workpiece with the etching target film formed thereon is placed is not limited, but is usually 0.1 kPa or higher and 101.3 kPa or lower.

The pressure in the processing vessel in the first etching step and the pressure in the processing vessel in the second etching step are each preferably 2.67 kPa or higher and 39.9 kPa or lower, more preferably 2.67 kPa or higher and 26.7 kPa or lower, in order to achieve a sufficient etching rate.

Although the processing time for the first etching step and the second etching step is not limited, the processing time in one cycle for the first etching step is preferably within 60 minutes, and the processing time in one cycle for the second etching step is preferably within 60 minutes. Here, the processing time for each etching step refers to the time from when the etching gas is introduced into the processing vessel in which the workpiece has been placed to when the etching gas in the processing vessel is then exhausted by the vacuum pump or the like to terminate the etching process.

### (Method I for producing semiconductor device)

The dry etching method I of the present disclosure described above is usable as an etching method for forming a predetermined pattern on an indium oxide film, a gallium oxide film, or other film in a conventional semiconductor device. When the dry etching method I of the present disclosure is used to etch an indium oxide film, a gallium oxide film, or other film on a substrate, a semiconductor device can be produced at a low cost.

A method for producing a semiconductor device according to the present disclosure is characterized by including applying the dry etching method I described above to a film containing the above-described metal, an oxide of the metal, or a nitride of the metal on a substrate to etch the film.

The dry etching method I of the present disclosure described above can be used to react a β-diketone and a gas containing a halogen atom in its molecule with the film, thereby etching the film.

### (Cleaning method)

A cleaning method according to the present disclosure is characterized by including bringing a β-diketone and a gas containing a halogen atom in its molecule into contact with a deposit containing at least one metal, an oxide of the metal, or a nitride of the metal deposited on a surface of a processing vessel in a substrate processing apparatus to remove the deposit, the at least one metal being selected from the group consisting of In, Ga, Cu, Co, Fe, Sn, Zn, Al, Ta, and As.

The conditions, procedure, and deposit used to bring the β-diketone and the gas containing a halogen atom in its molecule into contact with the deposit deposited on the surface of the processing vessel in the substrate processing apparatus are respectively similar to the conditions, procedure, and etching target film used to bring the β-diketone and the gas containing a halogen atom in its molecule into contact with the etching target film in the dry etching method I described above.

In the cleaning method of the present disclosure, the β-diketone and the gas containing a halogen atom in its molecule, when in the plasma state, may be brought into contact with the deposit, or the β-diketone and the gas containing a halogen atom in its molecule may be brought into contact with the deposit without plasma. The temperature of the deposit when the gas is brought into contact with the deposit is not limited and is, for example, 50°C or higher and 350°C or lower.

### (Dry etching method II)

A dry etching method II according to the present disclosure includes bringing a β-diketone and a gas containing a chlorine atom in its molecule into contact with an etching target film containing a metal, an oxide of the metal, or a nitride of the metal formed on a surface of a workpiece to etch the etching target film, the metal containing at least two selected from the group consisting of In, Co, Fe, As, Al, Ga, Sn, and Zn, the at least two including at least one selected from Ga, Sn, and Zn.

For example, when a β-diketone and NO₂ as an additive gas are brought into contact with an InGaZnO₄ film or the like, the composition of the etching target film may change before and after etching. This is presumably because Zn, which reacts with the β-diketone at low temperatures, exists in a small amount in the etched film, whereas Sn, Ga, and the like, which have low reactivity with the β-diketone, exist in a large amount in the etched film. The dry etching method II of the present disclosure uses as an additive gas a gas containing a chlorine atom in its molecule among gases containing halogen atoms in their molecule, and thus can provide a dry etching method which is less likely to cause a compositional change of an etching target film containing Ga, Sn, or Zn before and after etching.

The metal, the oxide of the metal, or the nitride of the metal in the etching target film to be etched by the dry etching method II of the present disclosure contains at least two selected from the group consisting of In, Co, Fe, As, Al, Ga, Sn, and Zn, and the at least two includes at least one selected from Ga, Sn, and Zn. Preferably, the metal, the oxide of the metal, or the nitride of the metal is at least one selected from the group consisting of indium gallium zinc oxides [InₐGa_{b}Zn_{c}O_{d} (a and b are each 1 or greater and 3 or smaller, c is 0.5 or greater and 4 or smaller, and d is 4 or greater and 10 or smaller; abbreviated as "IGZO"), particularly preferably represented by (InGaO₃)ₐ(ZnO)_{c} such as InGaZnO₄ and In₂Ga₂ZnO₇], indium zinc oxides, aluminum zinc oxides, gallium zinc oxides, indium gallium zinc tin oxides, indium tin zinc oxides, indium tin oxides, aluminum gallium nitrides, indium gallium nitrides, and indium gallium arsenide.

In the dry etching method II of the present disclosure, examples of the workpiece include those exemplified for the dry etching method I, and the workpiece may be one that has been subjected to a similar surface treatment. The method for forming the etching target film and the thickness of the etching target film can also be similar to those in the dry etching method I.

In the dry etching method II of the present disclosure, a β-diketone and a gas containing a chlorine atom in its molecule are used as an etching gas.

Examples of the type of β-diketone include those exemplified for the dry etching method I.

Any type of gas containing a chlorine atom in its molecule may be used. Preferred is at least one selected from the group consisting of HCl, Cl₂, BCl₃, and SiCl₄, with HCl, Cl₂, or BCl₃ being more preferred.

In the dry etching method II of the present disclosure, it is preferred to bring the β-diketone and the gas containing a chlorine atom in its molecule into contact with the etching target film without plasma. This is because if the workpiece is a semiconductor device substrate and is brought into contact with plasma gas, the plasma gas can cause electrical damage to the substrate.

### (Third dry etching method)

As the dry etching method II of the present disclosure, a third dry etching method is described below which includes simultaneously bringing the β-diketone and the gas containing a chlorine atom in its molecule (additive gas) into contact with the etching target film. In the third dry etching method, an etching gas D containing the β-diketone and the additive gas is brought into contact with the etching target film. The etching gas D contains at least the β-diketone and the gas containing a chlorine atom in its molecule.

The etching gas D preferably contains the β-diketone in an amount of 5% by volume or more and 99% by volume or less, more preferably 10% by volume or more and 90% by volume or less. Too low a β-diketone content in the etching gas D tends to lead to a decrease in etching rate, whereas too high a β-diketone content makes the etching gas too expensive. Moreover, either too low or too high an additive gas content in the etching gas D may inhibit the progress of etching.

The etching gas D preferably contains the additive gas (the gas containing a chlorine atom in its molecule) in an amount of 0.1% by volume or more and 65% by volume or less, more preferably 1% by volume or more and 60% by volume or less.

The volume ratio of the β-diketone to the additive gas (the gas containing a chlorine atom in its molecule) in the etching gas D may be β-diketone:additive gas = 1:0.01 to 100, or β-diketone:additive gas = 1:0.01 to 10, or β-diketone:additive gas = 1:0.01 to 1.

When the etching target film is formed of an indium gallium zinc oxide, the etching gas D preferably contains the gas containing a chlorine atom in its molecule in an amount of 2% by volume or more and 30% by volume or less, more preferably 2% by volume or more and 17% by volume or less.

When the etching target film is formed of an indium tin oxide, the etching gas D preferably contains the gas containing a chlorine atom in its molecule in a proportion of 1% by volume or more and 50% by volume or less, more preferably 1% by volume or more and 30% by volume or less.

When the etching target film is formed of an indium zinc oxide, the etching gas D preferably contains the gas containing a chlorine atom in its molecule in a proportion of 20% by volume or more and 60% by volume or less, more preferably 40% by volume or more and 60% by volume or less.

When the etching target film is formed of an aluminum gallium nitride, the etching gas D preferably contains the gas containing a chlorine atom in its molecule in a proportion of 10% by volume or more and 50% by volume or less, more preferably 15% by volume or more and 40% by volume or less.

The etching gas D may further contain an oxidative gas and may further contain an inert gas.

The types of oxidative gas and inert gas and the percentages of these gases in the etching gas D are as described for the etching gas A in the first dry etching method.

In the third dry etching method, etching is preferably performed with the workpiece placed in a processing vessel. The third dry etching method preferably includes subjecting the interior of the processing vessel to a reduced pressure condition after bringing the etching gas D into contact with the etching target film. This is because by-products generated during the etching can be removed.

The third dry etching method preferably includes purging the interior of the processing vessel with an inert gas after bringing the etching gas D into contact with the etching target film. This is because by-products generated during the etching can be removed.

The third dry etching method may include subjecting the interior of the processing vessel to a reduced pressure condition, followed by purging the interior of the processing vessel with an inert gas.

### (Fourth dry etching method)

Next, as the dry etching method II of the present disclosure, a fourth dry etching method is described which includes a third etching step including bringing an etching gas E containing the gas containing a chlorine atom in its molecule into contact with the etching target film, and a fourth etching step including bringing an etching gas F containing the β-diketone into contact with the etching target film. The etching gas E contains at least the gas containing a chlorine atom in its molecule (additive gas), while the etching gas F contains at least the β-diketone.

Although the etching gas E may consist only of the additive gas, and the etching gas F may consist only of the β-diketone, the etching gas E and/or the etching gas F may further contain any of the oxidative gases and inert gases described above.

The percentage of the additive gas in the etching gas E can be 10% by volume or more and 100% by volume or less, for example. The percentage of the β-diketone in the etching gas F can be 10% by volume or more and 100% by volume or less.

The types of oxidative gas and inert gas in the etching gas E and/or the etching gas F, the percentages of these gases in the etching gas E, and the percentages of these gases in the etching gas F are as described for the etching gas B and the etching gas C in the second dry etching method.

In the fourth dry etching method, etching is preferably performed with the workpiece placed in a processing vessel. The fourth dry etching method preferably includes subjecting the interior of the processing vessel to a reduced pressure condition after bringing the etching gas E and the etching gas F into contact with the etching target film. This is because by-products generated during the etching can be removed.

The fourth dry etching method preferably includes purging the interior of the processing vessel with an inert gas after bringing the etching gas E and the etching gas F into contact with the etching target film. This is because by-products generated during the etching can be removed.

The fourth dry etching method may include subjecting the interior of the processing vessel to a reduced pressure condition, followed by purging the interior of the processing vessel with an inert gas.

In the fourth dry etching method of the present disclosure, the above steps may be repeated multiple times to repeatedly etch the etching target film. Since one cycle of etching steps can etch the etching target film only to a certain thickness, a layer having a desired thickness can be precisely etched by specifying the number of cycles.

### (Etching conditions in third dry etching method)

The third dry etching method can be implemented, for example, using an etching apparatus as shown in FIG. 1. In the third dry etching method, the temperature of the etching target film during the etching may be any temperature at which the complex can vaporize, and is preferably 50°C or higher and 350°C or lower, more preferably 50°C or higher and 300°C or lower, still more preferably 100°C or higher and 300°C or lower, particularly preferably 150°C or higher and 300°C or lower.

Moreover, the pressure in the processing vessel during the etching is not limited, but is usually 0.1 kPa or higher and 101.3 kPa or lower.

The pressure in the processing vessel during the etching is preferably 2.67 kPa or higher and 39.9 kPa or lower, more preferably 2.67 kPa or higher and 26.7 kPa or lower, in order to achieve a sufficient etching rate.

The other etching conditions in the third dry etching method can be similar to the etching conditions in the first dry etching method.

### (Etching conditions in fourth dry etching method)

The fourth dry etching method can be implemented, for example, using an etching apparatus as shown in FIG. 1.

In the fourth dry etching method, the temperature of the etching target film in the third etching step and the temperature of the etching target film in the fourth etching step may each be any temperature at which the complex can vaporize, and are each preferably 50°C or higher and 350°C or lower, more preferably 50°C or higher and 300°C or lower, still more preferably 100°C or higher and 300°C or lower, particularly preferably 150°C or higher and 300°C or lower.

Moreover, when the etching gas E is brought into contact with the etching target film and when the etching gas F is brought into contact with the etching target film, the pressure in the processing vessel in which the workpiece with the etching target film formed thereon is placed is not limited, but is usually 0.1 kPa or higher and 101.3 kPa or lower.

The pressure in the processing vessel in the third etching step and the pressure in the processing vessel in the fourth etching step are each preferably 2.67 kPa or higher and 39.9 kPa or lower, more preferably 2.67 kPa or higher and 26.7 kPa or lower, in order to achieve a sufficient etching rate.

The other etching conditions in the fourth dry etching method can be similar to the etching conditions in the first etching step and the second etching step in the second dry etching method.

### (Method II for producing semiconductor device)

The dry etching method II of the present disclosure described above is usable as an etching method for forming a predetermined pattern on a film of a metal oxide such as InGaZnO₄. When the dry etching method II of the present disclosure is used to etch a film of InGaZnO₄ or other film on a substrate, a semiconductor device can be produced at a low cost.

A method II for producing a semiconductor device according to the present disclosure is characterized by including applying the dry etching method II described above to a film containing a metal, an oxide of the metal, or a nitride of the metal on a substrate to etch the film, the metal containing at least two selected from the group consisting of In, Co, Fe, As, Al, Ga, Sn, and Zn, the at least two including at least one selected from Ga, Sn, and Zn.

The dry etching method II of the present disclosure described above can be used to react a β-diketone and a gas containing a chlorine atom in its molecule with the film, thereby etching the film.

### EXAMPLES

Examples of the present disclosure are described below along with comparative examples although the present disclosure is not limited to the following examples.

### (Example 1)

An etching apparatus 100 as shown in FIG. 1 was used to etch a workpiece 10 having an etching target film made of an indium oxide (In₂O₃) film (shape: 1 cm × 1 cm; film thickness: 100 nm) formed on the surface of a silicon wafer (shape: 1 cm × 1 cm, thickness: 1000 µm).

The interior of a processing vessel 110, a pipe 121, pipes 131 and 132, pipes 141 and 142, pipes 151 and 152, pipes 191 and 192, and a liquid nitrogen trap 194 was evacuated to lower than 10 Pa using a vacuum pump 193. Then, the workpiece 10, placed in a placement unit 111, was heated with heating means 190 and a heater (not shown) installed within the placement unit 111. After confirming that the temperature of the workpiece 10 reached 250°C, gaseous HFAc and HF gas were supplied to the pipe 121 at predetermined flow rates from a β-diketone gas supply unit 130 and an additive gas supply unit 140, respectively, to introduce an etching gas into the processing vessel 110, while controlling the pressure in the processing vessel 110 to 13.3 kPa, thereby performing an etching step. The temperature of the workpiece 10 was 250°C, and the etching gas flow rates were as follows: HFAc = 9 sccm and HF = 1 sccm. After 20 minutes from the start of the introduction of the etching gas, the introduction of the etching gas was stopped. The interior of the processing vessel 110 was then evacuated to lower than 10 Pa and purged with N₂ gas supplied from an inert gas supply unit 150 before the workpiece 10 was taken out. The film thickness was measured to evaluate the etching rate. Table 1 shows the results.

### (Example 2, Comparative Examples 1 to 5)

The following Table 1 shows the types of additive gas, oxidative gas, and inert gas, and the flow rates of these gases, the pressure in the processing vessel, the temperature during the etching, and the etching rate.

The differences between Example 1 and each of Example 2 and Comparative Examples 1 to 5 are described. In Example 2, the temperature was changed to 300°C. In Comparative Example 1, the oxidative gas NO was used instead of HF. In Comparative Example 2, O₂ was used instead of HF. In Comparative Examples 3 and 4, NO₂ was used instead of HF. In Comparative Example 5, NO and NO₂ were used instead of HF. Here, in Comparative Examples 1 to 5, the flow rate of HFAc was 10 sccm, and the temperature was changed as shown in Table 1. Moreover, the flow rate of the additive gas(es) and the pressure in the processing vessel were as shown in Table 1. The difference between Comparative Example 3 and Comparative Example 4 is temperature. The procedure was otherwise the same as in Example 1, and the etching rate of the etching target film was evaluated. Table 1 shows the results.

### (Examples 3 to 14, Comparative Examples 6 to 23)

An etching apparatus 100 as shown in FIG. 1 was used to etch a workpiece having a gallium oxide (Ga₂O₃) film with a film thickness of 100 nm formed on the surface of a silicon wafer, an indium gallium zinc oxide (InGaZnO₄) film with a film thickness of 10 nm formed on the surface of a silicon wafer, a gallium nitride (GaN) film with a film thickness of 3.4 µm formed on the surface of a sapphire wafer, a tantalum (Ta) film with a film thickness of 50 nm formed on the surface of a silicon wafer, an indium tin oxide (In₂O₃:SnO₂ = 9:1, denoted as InSnOₓ in the following Table 1) film with a film thickness of 100 nm formed on the surface of a silicon wafer, a hafnium oxide (HfO₂) film with a film thickness of 60 nm formed on the surface of a silicon wafer, or a zirconium oxide (ZrO₂) film with a film thickness of 60 nm formed on the surface of a silicon wafer.

The same procedure as in Example 1 was performed, except that the material of the etching target film, the type and flow rate of the β-diketone for etching, the types and flow rates of the additive gas, oxidative gas, and inert gas, the pressure in the processing vessel, and the temperature of the etching target film during etching were changed as shown in Table 1. Thus, the etching rate of the etching target film was evaluated and Table 1 shows the results.

**[Table 1]**

| | Etching target film | β-diketone | | Additive gas, oxidative gas, inert gas | | | | Pressure | Temperature | Etching rate |
|---|---|---|---|---|---|---|---|---|---|---|
| | | Type | Flow rate | Type | Flow rate | Type | Flow rate | | | |
| | | | [sccm] | | [sccm] | | [sccm] | [kPa] | [°C] | [nm/min] |
| Example 1 | In₂O₃ | HFAc | 9 | HF | 1 | - | - | 13.3 | 250 | 1.1 |
| Example 2 | In₂O₃ | HFAc | 9 | HF | 1 | - | - | 13.3 | 300 | 2.1 |
| Comparative Example 1 | In₂O₃ | HFAc | 10 | NO | 5 | - | - | 12.0 | 300 | ≤ 0.1 |
| Comparative Example 2 | In₂O₃ | HFAc | 10 | O₂ | 5 | - | - | 12.0 | 300 | ≤ 0.1 |
| Comparative Example 3 | In₂O₃ | HFAc | 10 | NO₂ | 5 | - | - | 12.0 | 250 | ≤ 0.1 |
| Comparative Example 4 | In₂O₃ | HFAc | 10 | NO₂ | 5 | - | - | 12.0 | 300 | 0.5 |
| Comparative Example 5 | In₂O₃ | HFAc | 10 | NO | 1 | NO₂ | 5 | 12.8 | 300 | 1.5 |
| Example 3 | Ga₂O₃ | HFAc | 9 | HF | 1 | - | - | 13.3 | 250 | 1.6 |
| Example 4 | Ga₂O₃ | HFAc | 9 | HF | 1 | - | - | 13.3 | 300 | 10.1 |
| Comparative Example 6 | Ga₂O₃ | HFAc | 10 | NO | 5 | - | - | 12.0 | 300 | ≤ 0.1 |
| Comparative Example 7 | Ga₂O₃ | HFAc | 10 | O₂ | 5 | - | - | 12.0 | 300 | ≤ 0.1 |
| Comparative Example 8 | Ga₂O₃ | HFAc | 10 | NO₂ | 5 | - | - | 12.0 | 250 | ≤ 0.1 |
| Comparative Example 9 | Ga₂O₃ | HFAc | 10 | NO₂ | 5 | - | - | 12.0 | 300 | 1.0 |
| Comparative Example 10 | Ga₂O₃ | HFAc | 10 | NO | 10 | NO₂ | 5 | 18.0 | 250 | 0.4 |
| Comparative Example 11 | Ga₂O₃ | HFAc | 10 | NO | 5 | NO₂ | 5 | 14.0 | 300 | 7.4 |
| Example 5 | InGaZnO₄ | HFAc | 9 | HF | 1 | - | - | 13.3 | 250 | 0.4 |
| Example 6 | InGaZnO₄ | HFAc | 9 | HF | 1 | - | - | 13.3 | 300 | 7.1 |
| Comparative Example 12 | InGaZnO₄ | HFAc | 10 | NO | 5 | - | - | 12.0 | 300 | ≤ 0.1 |
| Comparative Example 13 | InGaZnO₄ | HFAc | 10 | O₂ | 5 | - | - | 12.0 | 300 | ≤ 0.1 |
| Comparative Example 14 | InGaZnO₄ | HFAc | 10 | NO₂ | 5 | - | - | 12.0 | 250 | ≤ 0.1 |
| Comparative Example 15 | InGaZnO₄ | HFAc | 10 | NO₂ | 5 | - | - | 12.0 | 300 | 2.4 |
| Comparative Example 16 | InGaZnO₄ | HFAc | 10 | NO | 1 | NO₂ | 5 | 12.8 | 300 | 5.8 |
| Example 7 | GaN | HFAc | 9 | HF | 1 | - | - | 13.3 | 250 | 0.4 |
| Example 8 | GaN | HFAc | 9 | HF | 1 | - | - | 13.3 | 300 | 1.1 |
| Comparative Example 17 | GaN | HFAc | 10 | NO | 5 | - | - | 12.0 | 300 | ≤ 0.1 |
| Comparative Example 18 | GaN | HFAc | 10 | O₂ | 5 | - | - | 12.0 | 300 | ≤ 0.1 |
| Comparative Example 19 | GaN | HFAc | 10 | NO₂ | 5 | - | - | 12.0 | 300 | 0.2 |
| Comparative Example 20 | GaN | HFAc | 10 | NO | 1 | NO₂ | 5 | 12.8 | 300 | 0.3 |
| Example 9 | Ta | HFAc | 10 | HF | 1.5 | N₂ | 8.5 | 13.3 | 200 | 0.6 |
| Example 10 | Ta | HFAc | 10 | HF | 1.5 | N₂ | 8.5 | 13.3 | 250 | 1.8 |
| Example 11 | Ta | HFAc | 10 | HF | 1.5 | O₂ | 8.5 | 13.3 | 200 | 2.3 |
| Example 12 | Ta | HFAc | 10 | HF | 1.5 | O₂ | 8.5 | 13.3 | 250 | 5.6 |
| Comparative Example 21 | Ta | HFAc | 10 | O₂ | 10 | - | - | 13.3 | 200 | ≤ 0.1 |
| Comparative Example 22 | Ta | HFAc | 10 | O₂ | 10 | - | - | 13.3 | 250 | ≤ 0.1 |
| Example 13 | InSnOₓ | HFAc | 10 | HF | 5 | - | - | 12.0 | 200 | 0.9 |
| Example 14 | InSnOₓ | HFAc | 10 | HCl | 5 | - | - | 12.0 | 200 | 2.1 |
| Comparative Example 23 | InSnOₓ | HFAc | 10 | NO₂ | 5 | - | - | 12.0 | 200 | ≤ 0.1 |

Comparison between Example 1 and Comparative Example 3 shows that the etching rate of the In₂O₃ film at 250°C was low when NO₂ was used instead of HF, whereas the etching rate of the In₂O₃ film at 250°C increased when HF was used. Comparison between Example 2 and Comparative Examples 1 and 2 shows that the etching rate of the In₂O₃ film at 300°C was low when NO or O₂ was used instead of HF, whereas the etching rate of the In₂O₃ film at 300°C increased when HF was used. Moreover, comparison between Example 2 and Comparative Examples 4 and 5 shows that the etching rate of the In₂O₃ film was 0.5 nm/min when NO₂ was used instead of HF, and the etching rate of the In₂O₃ film was 1.5 nm/min when NO and NO₂ were used instead of HF, whereas the etching rate was 2.1 nm/min when HF was used, indicating that the use of HF increases the etching rate of the In₂O₃ film at 300°C.

Comparison between Example 3 and Comparative Example 8 shows that the etching rate of the Ga₂O₃ film at 250°C was low when NO₂ was used instead of HF, whereas the etching rate of the Ga₂O₃ film at 250°C increased when HF was used. Comparison between Example 3 and Comparative Example 10 shows that the etching rate of Ga₂O₃ at 250°C was 0.4 nm/min when NO and NO₂ were used instead of HF, whereas the etching rate of the Ga₂O₃ film at 250°C was 1.6 nm/min when HF was used, indicating that the use of HF increases the etching rate about fourfold. Comparison between Example 4 and Comparative Examples 6 and 7 shows that the etching rate of the Ga₂O₃ film at 300°C was low when NO or O₂ was used instead of HF, whereas the etching rate of the Ga₂O₃ film at 300°C increased when HF was used. Moreover, comparison between Example 4 and Comparative Examples 9 and 11 shows that the etching rate of the Ga₂O₃ film at 300°C was 1.0 nm/min when NO₂ was used instead of HF, and the etching rate of the Ga₂O₃ film at 300°C was 7.4 nm/min when NO and NO₂ were used instead of HF, whereas the etching rate at 300°C was 10.1 nm/min when HF was used, indicating that the addition of HF increases the etching rate of the Ga₂O₃ film at 300°C.

Comparison between Example 5 and Comparative Example 14 shows that the etching rate of the InGaZnO₄ film at 250°C was low when NO₂ was used instead of HF, whereas the etching rate of the InGaZnO₄ film at 250°C increased when HF was used. Comparison between Example 6 and Comparative Examples 12 and 13 shows that the etching rate of the InGaZnO₄ film at 300°C was low when NO or O₂ was used instead of HF, whereas the etching rate of the InGaZnO₄ film increased when HF was used. Moreover, comparison between Example 6 and Comparative Examples 15 and 16 shows that the etching rate of the InGaZnO₄ film at 300°C was 2.4 nm/min when NO₂ was used instead of HF, and the etching rate of the InGaZnO₄ film at 300°C was 5.8 nm/min when NO and NO₂ were used instead of HF, whereas the etching rate of the InGaZnO₄ film at 300°C was 7.1 nm/min when HF was used, indicating that the use of HF increases the etching rate of the InGaZnO₄ film at 300°C.

Comparison between Example 8 and Comparative Examples 17 and 18 shows that the etching rate of the GaN film at 300°C was low when NO or O₂ was used instead of HF, whereas the etching rate of the GaN film at 300°C increased when HF was used. Moreover, comparison between Example 8 and Comparative Examples 19 and 20 shows that the etching rate of the GaN film at 300°C was 0.2 nm/min when NO₂ was used instead of HF, and the etching rate of the GaN film at 300°C was 0.3 nm/min when NO and NO₂ were used as additive gases instead of HF, whereas the etching rate of the GaN film at 300°C was 1.1 nm/min when HF was used, indicating that the use of HF increases the etching rate of the GaN film at 300°C.

The etching rates of In₂O₃ and InGaZnO₄ at a temperature of 250°C were found to be low when O₂ or NO₂ was added, but to increase when HF was added. It was also confirmed that the etching rate at each temperature was highest when HF was added. Thus, using a β-diketone and HF makes it possible to perform etching in a temperature range where etching was previously impossible, and to increase the etching rate.

The results of Examples 9 to 12 revealed that the use of HFAc and HF increased the etching rate of the Ta film at 200°C or 250°C. Comparison between Example 11 and Comparative Example 21 shows that the etching rate of the Ta film at 200°C was low when O₂ was used with no additive gas, whereas the etching rate of the Ta film at 200°C increased when O₂ and HF as an additive gas were used. Comparison between Example 12 and Comparative Example 22 shows that the etching rate of the Ta film at 250°C was low when O₂ was used with no additive gas, whereas the etching rate of the Ta film at 250°C increased when O₂ and HF as an additive gas were used. Moreover, comparison between Example 9 and Example 11 shows that the etching rate of the Ta film at 200°C was 0.6 nm/min when HF as an additive gas and N₂ as an inert gas were used, whereas the etching rate of the Ta film at 200°C was 2.3 nm/min when HF and the oxidative gas O₂ were used, indicating that the simultaneous use of HF and the oxidative gas O₂ increases the etching rate of the Ta film at 200°C. Likewise, comparison between Example 10 and Example 12 shows that the simultaneous use of HF and O₂ also increases the etching rate of the Ta film at 250°C.

Comparison between Example 13 and Comparative Example 23 shows that the etching rate of the InSnOₓ film at 200°C was low when NO₂ was used instead of HF, whereas the etching rate of the InSnOₓ film at 200°C increased when HF was used. Comparison between Example 13 and Example 14 shows that the etching rate of the InSnOₓ film at 200°C was 0.9 nm/min when HF was used, whereas the etching rate of the InSnOₓ film at 200°C was 2.1 nm/min when HCl was used instead of HF, indicating that the addition of HCl increases the etching rate of the InSnOₓ film at 200°C.

### (Example 15)

An etching apparatus 100 as shown in FIG. 1 was used to etch a workpiece 10 having an etching target film made of an indium oxide (In₂O₃) film (shape: 1 cm × 1 cm, film thickness: 100 nm) formed on the surface of a silicon wafer (shape: 1 cm × 1 cm, thickness: 1000 µm).

The interior of a processing vessel 110, a pipe 121, pipes 131 and 132, pipes 141 and 142, pipes 151 and 152, pipes 191 and 192, and a liquid nitrogen trap 194 was evacuated to lower than 10 Pa using a vacuum pump 193. Then, the workpiece 10, placed in a placement unit 111, was heated with heating means 190 and a heater (not shown) installed within the placement unit 111. After confirming that the temperature of the workpiece 10 reached 200°C, F₂ gas was supplied to the pipe 121 at a predetermined flow rate from an additive gas supply unit 140 to introduce F₂ gas into the processing vessel 110, while controlling the pressure in the processing vessel 110 to 12.0 kPa, thereby performing a first etching step. The temperature of the workpiece 10 was 200°C, and the etching gas flow rate was as follows: F₂ gas = 10 sccm. After 5 minutes from the start of the introduction of F₂ gas, the supply of F₂ gas was stopped. The interior of the processing vessel 110 was then evacuated to lower than 10 Pa. Then, gaseous HFAc was supplied to the pipe 121 at a predetermined flow rate from a β-diketone gas supply unit 130 to introduce an etching gas into the processing vessel 110, while controlling the pressure in the processing vessel 110 to 12.0 kPa, thereby performing a second etching step. The temperature of the workpiece 10 was 200°C, and the flow rate of HFAc gas was as follows: HFAc = 10 sccm. After 5 minutes from the start of the introduction of HFAc gas, the introduction of HFAc gas was stopped. The interior of the processing vessel 110 was then evacuated to lower than 10 Pa. The first etching step and the second etching step were repeated 10 times, followed by purging the interior of the processing vessel 110 with N₂ gas supplied from an inert gas supply unit 150 before the workpiece 10 was taken out. The film thickness was measured to evaluate the etching rate. Table 2 shows the results.

### (Examples 16 to 20, Comparative Examples 24 to 27)

The same procedure as in Example 15 was performed, except that the type of gas for etching and the temperature of the etching target film during etching were changed as shown in Table 2. Thus, the etching rate of the etching target film was evaluated.

The differences between Example 15 and each of Examples 16 to 20 and Comparative Examples 24 to 27 are described. In Example 16, the gas flowing in the first etching step was changed to ClF₃. In Example 17, the gas flowing in the first etching step was changed to HCl. The difference between Examples 15 to 17 and Examples 18 to 20 is temperature. The gas flowing in the first etching step was O₂ in Comparative Examples 24 and 26 and NO in Comparative Examples 25 and 27. The difference between Comparative Example 24 and Comparative Example 26 is temperature. The difference between Comparative Example 25 and Comparative Example 27 is temperature. The procedure was otherwise the same as in Example 15, and the etching rate of the etching target film was evaluated. Table 2

**[Table 2]**

| | Etching target film | First etching step | | | | Second etching step | | | | Etching rate |
|---|---|---|---|---|---|---|---|---|---|---|
| | | Additive gas or oxidative gas | | Pressure | Temperature | β-diketone | | Pressure | Temperature | |
| | | Type | Flow rate | | | Type | Flow rate | | | |
| | | | [sccm] | [kPa] | [°C] | | [sccm] | [kPa] | [°C] | [nm/cycle] |
| Example 15 | In₂O₃ | F₂ | 10 | 12.0 | 200 | HFAc | 10 | 12.0 | 200 | 0.2 |
| Example 16 | In₂O₃ | ClF₃ | 10 | 12.0 | 200 | HFAc | 10 | 12.0 | 200 | 0.3 |
| Example 17 | In₂O₃ | HCl | 10 | 12.0 | 200 | HFAc | 10 | 12.0 | 200 | 1.1 |
| Example 18 | In₂O₃ | F₂ | 10 | 12.0 | 250 | HFAc | 10 | 12.0 | 250 | 0.9 |
| Example 19 | In₂O₃ | ClF₃ | 10 | 12.0 | 250 | HFAc | 10 | 12.0 | 250 | 0.8 |
| Example 20 | In₂O₃ | HCl | 10 | 12.0 | 250 | HFAc | 10 | 12.0 | 250 | 1.2 |
| Comparative Example 24 | In₂O₃ | O₂ | 10 | 12.0 | 200 | HFAc | 10 | 12.0 | 200 | ≤ 0.01 |
| Comparative Example 25 | In₂O₃ | NO | 10 | 12.0 | 200 | HFAc | 10 | 12.0 | 200 | ≤ 0.01 |
| Comparative Example 26 | In₂O₃ | O₂ | 10 | 12.0 | 250 | HFAc | 10 | 12.0 | 250 | ≤ 0.01 |
| Comparative Example 27 | In₂O₃ | NO | 10 | 12.0 | 250 | HFAc | 10 | 12.0 | 250 | ≤ 0.01 |

Comparison between Example 15 and Comparative Examples 24 and 25 shows that the etching rate of the In₂O₃ film was low when O₂ and NO gases were used in the first etching step, whereas the etching rate of the In₂O₃ film at 200°C increased when F₂ was used. Comparison between Example 18 and Comparative Examples 26 and 27 shows that, also at 250°C, the etching rate of the In₂O₃ film was low when O₂ and NO gases were used in the first etching step, whereas the etching rate of the In₂O₃ film increased when F₂ was used. Comparison between Examples 15, 16, and 17 shows that the etching rate of the In₂O₃ film at 200°C was 0.2 nm/cycle when F₂ gas was used in the first etching step, and the etching rate of the In₂O₃ film at 200°C was 0.3 nm/cycle when ClF₃ was used, whereas the etching rate of the In₂O₃ film at 200°C was 1.1 nm/cycle when HCl gas was used in the first etching step, indicating that the use of HCl gas in the first etching step increases the etching rate of the In₂O₃ film at 200°C. Comparison between Examples 15 to 17 and Examples 18 to 20 shows that the etching rate at 250°C increased compared to the etching rate at 200°C when F₂, ClF₃, or HCl gas was used in the first etching step.

### (Example 21)

An etching apparatus 100 as shown in FIG. 1 was used to etch a workpiece 10 having an etching target film made of an In₂Ga₂ZnO₆ film (shape: 1 cm × 1 cm, film thickness: 100 nm) formed on the surface of a silicon wafer (shape: 1 cm × 1 cm, thickness: 1000 µm).

The interior of a processing vessel 110, a pipe 121, pipes 131 and 132, pipes 141 and 142, pipes 151 and 152, pipes 191 and 192, and a liquid nitrogen trap 194 was evacuated to lower than 10 Pa. Then, the workpiece 10, placed in a placement unit 111, was heated with heating means 190 and a heater (not shown) installed within the placement unit 111. After confirming that the temperature of the workpiece 10 reached 200°C, gaseous hexafluoroacetylacetone (HFAc) and HCl gas were supplied to the pipe 121 at predetermined flow rates from a β-diketone gas supply unit 130 and an additive gas supply unit 140, respectively, to introduce an etching gas into the processing vessel 110, while controlling the pressure in the processing vessel 110 to 1.33 kPa, thereby performing an etching step. The temperature of the workpiece 10 was 200°C, and the gas composition ratio by volume of the etching gas was HFAc:HCl = 96:4. After 5 minutes from the start of the introduction of the etching gas, the introduction of the etching gas was stopped. The interior of the processing vessel 110 was then evacuated to lower than 10 Pa and purged with N₂ gas supplied from an inert gas supply unit 150 before the workpiece 10 was taken out. The film thickness was measured to evaluate the etching rate and the elemental composition ratio of the film surface after etching. Here, the elemental composition was analyzed by X-ray photoelectron spectroscopy (XPS) (PHI5000 VersaProbe II available from Ulvac-Phi, Inc.). Table 3 shows the results.

### (Examples 22 to 26, Comparative Examples 28 to 30)

Table 3 below shows the type of additive gas for etching, the flow rate of each additive gas, the pressure in the processing vessel, the temperature during etching, the etching rate, and the elemental composition ratio before and after etching in each of Examples 21 to 26 and Comparative Examples 28 to 30.

The differences between Example 21 and each of Examples 22 to 26 and Comparative Examples 28 to 30 are described. In Example 22 and Comparative Example 28, the gas composition of the etching gas was changed to HFAc:HCl = 90:10 for Example 22 and HFAc:HCl = 100:0 for Comparative Example 28. In Example 23, the temperature was changed to 300°C. In Example 24, the pressure in the vessel was 13.3 kPa and the temperature was 175°C. In Example 25, the gas composition ratio of the etching gas was HFAc:HCl = 85:15, the pressure in the vessel was 0.66 kPa, and the temperature was 275°C. In Example 26, Cl₂ gas was used instead of HCl. In Comparative Example 29, O₂ was used instead of HCl. In Comparative Example 30, NO₂ was used instead of HCl. Here, in Comparative Examples 29 and 30, the amount of HFAc in the etching gas was 67% by volume, and the pressure in the vessel and the temperature were changed as shown in Table 3. The procedure was otherwise the same as in Example 21, and the etching rate and elemental composition ratio of the etching target film were evaluated. Table 3 shows the results.

### (Examples 27 to 33)

An etching apparatus 100 as shown in FIG. 1 was used to etch a workpiece having an In₉SnO₁₅ film (shape: 1 cm × 1 cm, film thickness: 100 nm) formed on the surface of a silicon wafer, an In₂Zn₂O₅ film (shape: 1 cm × 1 cm, film thickness: 100 nm) formed on the surface of a silicon wafer, or an AlGa₁₀N₁₀ film (shape: 1 cm × 1 cm, film thickness: 1.2 µm) formed on the surface of a silicon wafer.

The same procedure as in Example 21 was performed, except that the material of the etching target film, the type and flow rate of the β-diketone for etching, the type and flow rate of the additive gas, the pressure in the processing vessel, and the temperature of the workpiece during etching were changed as shown in Table 3. Thus, the etching rate and elemental composition ratio of the etching target film were evaluated. Table 3 shows the results.

**[Table 3]**

| | Etching target film | β-diketone | | Additive gas | | Pressure | Temperature | Etching rate | Elemental composition ratio | | | | | | | |
|---|---|---|---|---|---|---|---|---|---|---|---|---|---|---|---|---|
| | | Type | Flow rate | Type | Flow rate | | | | Before etching | | | | After etching | | | |
| | | | [sccm] | | [sccm] | [kPa] | [°C] | [nm/min] | a | b | c | d | a | b | c | d |
| Example 21 | InₐGa_{b}Zn_{c}O_{d} | HFAc | 96 | HCl | 4 | 1.33 | 200 | 1.3 | 2 | 2 | 1 | 6 | 2 | 2 | 1 | 6 |
| Example 22 | InₐGa_{b}Zn_{c}O_{d} | HFAc | 90 | HCl | 10 | 1.33 | 200 | 1.4 | 2 | 2 | 1 | 6 | 2 | 2 | 1 | 6 |
| Example 23 | InₐGa_{b}Zn_{c}O_{d} | HFAc | 96 | HCl | 4 | 1.33 | 300 | 3.6 | 2 | 2 | 1 | 6 | 2 | 2 | 1 | 6 |
| Example 24 | InₐGa_{b}Zn_{c}O_{d} | HFAc | 96 | HCl | 4 | 13.3 | 175 | 1.4 | 2 | 2 | 1 | 6 | 2 | 2 | 1 | 6 |
| Example 25 | InₐGa_{b}Zn_{c}O_{d} | HFAc | 85 | HCl | 15 | 0.66 | 275 | 1.0 | 2 | 2 | 1 | 6 | 2 | 2 | 1 | 6 |
| Example 26 | InₐGa_{b}Zn_{c}O_{d} | HFAc | 96 | Cl₂ | 4 | 1.33 | 200 | 0.2 | 2 | 2 | 1 | 6 | 2 | 2 | 1 | 6 |
| Comparative Example 28 | InₐGa_{b}Zn_{c}O_{d} | HFAc | 100 | - | - | 1.33 | 200 | ≤ 0.1 | 2 | 2 | 1 | 6 | - | - | - | - |
| Comparative Example 29 | InₐGa_{b}Zn_{c}O_{d} | HFAc | 67 | O₂ | 33 | 12.0 | 300 | ≤ 0.1 | 2 | 2 | 1 | 6 | - | - | - | - |
| Comparative Example 30 | InₐGa_{b}Zn_{c}O_{d} | HFAc | 67 | NO₂ | 33 | 13.3 | 300 | 2.4 | 2 | 2 | 1 | 6 | 3 | 3 | 1 | 6 |
| Example 27 | InₐSn_{b}O_{c} | HFAc | 98 | HCl | 2 | 13.3 | 150 | 3.8 | 9 | 1 | 15 | - | 9 | 1 | 15 | - |
| Example 28 | InₐSn_{b}O_{c} | HFAc | 70 | Cl₂ | 30 | 13.3 | 150 | 1.6 | 9 | 1 | 15 | - | 9 | 1 | 15 | - |
| Example 29 | InₐZn_{b}O_{c} | HFAc | 50 | HCl | 50 | 6.7 | 200 | 2.1 | 2 | 2 | 5 | - | 2 | 2 | 5 | - |
| Example 30 | InₐZn_{b}O_{c} | HFAc | 50 | Cl₂ | 50 | 6.7 | 200 | 1.4 | 2 | 2 | 5 | - | 2 | 2 | 5 | - |
| Example 31 | InₐZn_{b}O_{c} | HFAc | 50 | BCl₃ | 50 | 6.7 | 200 | 2.8 | 2 | 2 | 5 | - | 2 | 2 | 5 | - |
| Example 32 | AlₐGa_{b}N_{c} | HFAc | 80 | HCl | 20 | 13.3 | 300 | 1.6 | 1 | 10 | 10 | - | 1 | 10 | 10 | - |
| Example 33 | AlₐGa_{b}N_{c} | HFAc | 70 | Cl₂ | 30 | 13.3 | 300 | 0.9 | 1 | 10 | 10 | - | 1 | 10 | 10 | - |

Comparison between Example 21 and Comparative Examples 28 and 29 shows that the etching rate was low when HFAc was used alone and when O₂ was used instead of HCl, whereas the etching rate of the In₂Ga₂ZnO₆ film increased when a gas mixture of HFAc and HCl was used. The results of Examples 21, 22, and 25 show that In₂Ga₂ZnO₆ could be etched without changing its composition when the gas composition was HFAc:HCl = 96:4, 90:10, or 85:15. The results of Example 21 and Examples 23 to 25 show that the composition of In₂Ga₂ZnO₆ did not change after etching at 175°C, 200°C, 275°C, or 300°C when HFAc and HCl were used. It is also shown that the composition of In₂Ga₂ZnO₆ did not change after etching also when the pressure in the vessel was 0.66 kPa, 1.33 kPa, or 13.3 kPa.

Comparison between Example 21 and Comparative Example 30 shows that the elemental composition ratio after etching was a:b:c:d = 3:3:1:6 in Comparative Example 30 in which NO₂ was used instead of HCl, whereas In₂Ga₂ZnO₆ could be etched without changing its composition in Example 21 in which HCl was used. The results of Examples 21 and 26 show that the composition of In₂Ga₂ZnO₆ did not change after etching also when Cl₂ was used instead of HCl, indicating that the change in composition of In₂Ga₂ZnO₆ after etching could be suppressed also when Cl₂ was used as an additive gas.

The results of Example 27 show that the change in composition of In₉SnO₁₅ after etching could be suppressed when HCl was used as an additive gas. The results of Example 28 show that In₉SnO₁₅ could be etched without changing its composition also when Cl₂ was used as an additive gas instead of HCl.

The results of Example 29 show that the change in composition of In₂Zn₂O₅ after etching could be suppressed when HCl was used as an additive gas. The results of Examples 30 and 31 show that In₂Zn₂O₅ could be etched without changing its composition also when Cl₂ or BCl₃ was used as an additive gas instead of HCl.

The results of Example 32 show that the change in composition of AlGa₁₀N₁₀ after etching could be suppressed when HCl was used as an additive gas. The results of Example 33 show that AlGa₁₀N₁₀ could be etched without changing its composition also when Cl₂ was used as an additive gas instead of HCl.

### REFERENCE SIGNS LIST

- 10: workpiece
- 100: etching apparatus
- 110: processing vessel
- 111: placement unit
- 121: pipe
- 130: β-diketone gas supply unit
- 131, 132: pipe
- 140: additive gas supply unit
- 141, 142: pipe
- 150: inert gas supply unit
- 151, 152: pipe
- 190: heating means
- 191, 192: pipe
- 193: vacuum pump
- 194: liquid nitrogen trap
- MFC1, MFC2, MFC3: mass flow control means
- PI1, PI2: pressure indicator
- V1, V2, V3, V4, V5, V6, V7, V8: valve

## Claims

1. A dry etching method, comprising
bringing a β-diketone and a gas containing a halogen atom in its molecule into contact with an etching target film containing a metal, an oxide of the metal, or a nitride of the metal formed on a surface of a workpiece to etch the etching target film, the metal comprising at least one selected from the group consisting of In, Ga, Cu, Co, Fe, Sn, Zn, Al, Ta, and As.

2. The dry etching method according to claim 1,
wherein the metal, the oxide of the metal, or the nitride of the metal is at least one selected from the group consisting of indium oxides, gallium oxides, copper oxides, cobalt oxides, iron oxides, tin oxides, zinc oxides, aluminum oxides, tantalum oxides, indium gallium zinc oxides, indium tin oxides, gallium nitride, indium nitride, aluminum nitride, tantalum nitride, aluminum gallium nitrides, indium gallium nitrides, and indium gallium arsenide.

3. The dry etching method according to claim 1,
wherein the gas containing a halogen atom in its molecule is at least one selected from the group consisting of HF, F₂, ClF₃, IF₇, HCl, and Cl₂.

4. The dry etching method according to claim 1,
wherein the β-diketone is at least one selected from the group consisting of hexafluoroacetylacetone, trifluoroacetylacetone, and acetylacetone.

5. The dry etching method according to claim 1,
wherein the etching is performed without plasma.

6. The dry etching method according to claim 1,
wherein an etching gas A containing the β-diketone and the gas containing a halogen atom in its molecule is brought into contact with the etching target film.

7. The dry etching method according to claim 6,
wherein the etching target film has a temperature of 50°C or higher and 300°C or lower when the etching gas A is brought into contact with the etching target film.

8. The dry etching method according to claim 6,
wherein the etching gas A contains the β-diketone in an amount of 10% by volume or more and 90% by volume or less.

9. The dry etching method according to claim 6,
wherein the etching gas A contains the gas containing a halogen atom in its molecule in an amount of 0.1% by volume or more and 50% by volume or less.

10. The dry etching method according to claim 6,
wherein the etching gas A further contains at least one oxidative gas selected from the group consisting of O₂, NO, NO₂, and N₂O.

11. The dry etching method according to claim 6,
wherein the etching gas A further contains at least one inert gas selected from the group consisting of N₂, Ar, He, Ne, and Kr.

12. The dry etching method according to claim 6,
wherein a pressure in a processing vessel in which the workpiece with the etching target film formed thereon is placed is 0.1 kPa or higher and 101.3 kPa or lower when the etching gas A is brought into contact with the etching target film.

13. The dry etching method according to claim 1, comprising:
a first etching step comprising bringing an etching gas B containing the gas containing a halogen atom in its molecule into contact with the etching target film; and
a second etching step comprising bringing an etching gas C containing the β-diketone into contact with the etching target film.

14. The dry etching method according to claim 13,
wherein the etching target film has a temperature of 50°C or higher and 300°C or lower when the etching gas B is brought into contact with the etching target film and when the etching gas C is brought into contact with the etching target film.

15. The dry etching method according to claim 13,
wherein at least one of the etching gas B or the etching gas C further contains at least one oxidative gas selected from the group consisting of O₂, NO, NO₂, and N₂O.

16. The dry etching method according to claim 13,
wherein at least one of the etching gas B or the etching gas C further contains at least one inert gas selected from the group consisting of N₂, Ar, He, Ne, and Kr.

17. The dry etching method according to claim 13,
wherein a pressure in a processing vessel in which the workpiece with the etching target film formed thereon is placed is 0.1 kPa or higher and 101.3 kPa or lower when the etching gas B is brought into contact with the etching target film and when the etching gas C is brought into contact with the etching target film.

18. A cleaning method, comprising
bringing a β-diketone and a gas containing a halogen atom in its molecule into contact with a deposit containing a metal, an oxide of the metal, or a nitride of the metal deposited on a surface of a processing vessel in a substrate processing apparatus to remove the deposit, the metal containing at least one selected from the group consisting of In, Ga, Cu, Co, Fe, Sn, Zn, Al, Ta, and As.

19. The cleaning method according to claim 18,
wherein the metal, the oxide of the metal, or the nitride of the metal is at least one selected from the group consisting of indium oxides, gallium oxides, copper oxides, cobalt oxides, iron oxides, tin oxides, zinc oxides, aluminum oxides, tantalum oxides, indium gallium zinc oxides, indium tin oxides, gallium nitride, indium nitride, aluminum nitride, tantalum nitride, aluminum gallium nitrides, indium gallium nitrides, and indium gallium arsenide.

20. The cleaning method according to claim 18,
wherein at least one oxidative gas selected from the group consisting of O₂, NO, NO₂, and N₂O is further brought into contact with the deposit.

21. A method for producing a semiconductor device, comprising
applying the dry etching method according to any one of claims 1 to 17 to a film containing a metal, an oxide of the metal, or a nitride of the metal on a substrate to etch the film, the metal containing at least one selected from the group consisting of In, Ga, Cu, Co, Fe, Sn, Zn, Al, Ta, and As.

22. A dry etching method, comprising
bringing a β-diketone and a gas containing a chlorine atom in its molecule into contact with an etching target film containing a metal, an oxide of the metal, or a nitride of the metal formed on a surface of a workpiece to etch the etching target film, the metal containing at least two selected from the group consisting of In, Co, Fe, As, Al, Ga, Sn, and Zn, the at least two including at least one selected from Ga, Sn, and Zn.

23. The dry etching method according to claim 22,
wherein the metal, the oxide of the metal, or the nitride of the metal is at least one selected from the group consisting of indium gallium zinc oxides, indium zinc oxides, aluminum zinc oxides, gallium zinc oxides, indium gallium zinc tin oxides, indium tin zinc oxides, indium tin oxides, aluminum gallium nitrides, indium gallium nitrides, and indium gallium arsenide.

24. The dry etching method according to claim 22,
wherein the gas containing a chlorine atom in its molecule is at least one selected from the group consisting of HCl, Cl₂, BCl₃, and SiCl₄.

25. The dry etching method according to claim 22,
wherein the β-diketone is at least one selected from the group consisting of hexafluoroacetylacetone, trifluoroacetylacetone, and acetylacetone.

26. The dry etching method according to claim 22,
wherein the etching is performed without plasma.

27. The dry etching method according to claim 22,
wherein an etching gas D containing the β-diketone and the gas containing a chlorine atom in its molecule is brought into contact with the etching target film.

28. The dry etching method according to claim 27,
wherein the etching gas D contains the gas containing a chlorine atom in its molecule in an amount of 1% by volume or more and 60% by volume or less.

29. The dry etching method according to claim 22, comprising:
a third etching step comprising bringing an etching gas E containing the gas containing a chlorine atom in its molecule into contact with the etching target film; and
a fourth etching step comprising bringing an etching gas F containing the β-diketone into contact with the etching target film.

30. A method for producing a semiconductor device, comprising
applying the dry etching method according to any one of claims 22 to 29 to a film containing a metal, an oxide of the metal, or a nitride of the metal on a substrate to etch the film, the metal containing at least two selected from the group consisting of In, Co, Fe, As, Al, Ga, Sn, and Zn, the at least two including at least one selected from Ga, Sn, and Zn.
